**Europäisches Patentamt**

(19) **European Patent Office**

**Office européen des brevets**

(11) Veröffentlichungsnummer: **0 025 805**
**B1**

(12) **EUROPÄISCHE PATENTSCHRIFT**

(45) Veröffentlichungstag der Patentschrift:
06.04.83

(51) Int. Cl.³: **G 03 F 7/20,** G 03 F 7/02,
H 01 L 21/312, H 01 L 21/00

(21) Anmeldenummer: **79103567.8**

(22) Anmeldetag: **21.09.79**

(54) Verfahren zur Übertragung eines Musters auf eine Halbleiterscheibe.

(43) Veröffentlichungstag der Anmeldung:
01.04.81 Patentblatt 81/13

(73) Patentinhaber: **CENSOR Patent- und Versuchs-Anstalt,
Schlossstrasse 5, FL-9490 Vaduz (LI)**

(45) Bekanntmachung des Hinweises auf die Patenterteilung:
06.04.83 Patentblatt 83/14

(72) Erfinder: **Löbach, Ernst, Dr., Tonagass 374,
FL-9492 Eschen (LI)**

(84) Benannte Vertragsstaaten:
**AT BE CH DE FR GB IT LU NL SE**

(74) Vertreter: **Hofinger, Engelbert, DDr.,
Wilhelm-Greil-Strasse 16, A-6020 Innsbruck (AT)**

(56) Entgegenhaltungen:
DE-A-1 622 302
FR-A-2 263 605
US-A-3 573 975

IBM TECHNICAL DISCLOSURE BULLETIN, Band 12,
Nr. 9, Februar 1970, New York, US, W.M. MOREAU:
«Topcoat formulation for oxygen sensitive resists», Seiten 1418–1419
IBM TECHNICAL DISCLOSURE BULLETIN, Band 21,
Nr. 6, November 1978, New York, US, B.C. FENG et al.:
«Fabrication of devices by an improved photolithographic method», Seiten 2325–2326

## Verfahren zur Übertragung eines Musters auf eine Halbleiterscheibe

Bei der Herstellung integrierter Schaltungen geht man so vor, dass eine Anzahl von Masken mit verschiedenen Konfigurationen auf ein Substrat abgebildet wird, dessen Oberfläche durch Belichtung verändert wird. Zwischen aufeinanderfolgenden Abbildungen wird das Substrat physikalischen und chemischen Änderungen unterworfen, die beispielsweise darin bestehen können, dass der belichtete oder der unbelichtete Teil des auf das Substrat aufgebrachten Fotolacks entfernt und darunterliegende Schichten geätzt werden.

Durch moderne Dotiertechniken und hochentwickelte Verfahren zur Abscheidung von Schichten auf Halbleiteroberflächen ist heute die Strukturierung in vertikaler Richtung bei der Fertigung integrierter Schaltungen bereits in einem Ausmass möglich, hinter dem die Möglichkeiten zur Strukturierung in horizontaler Richtung weit zurückbleiben. Einer Verfeinerung der Strukturierung integrierter Schaltungen in der Lateraldimension der Halbleiterscheibe gelten daher derzeit intensive Bemühungen.

Während es früher üblich war, während des Belichtungsvorganges die mit dem abzubildenden Muster versehene Maske in unmittelbaren Kontakt mit dem Substrat zu bringen, ging man wegen den inzwischen gestiegenen Anforderungen an die Genauigkeit in jüngster Zeit weitgehend dazu über, die das abzubildende Muster tragende Maske unter Zwischenschaltung eines Objektivs zwischen Maske und Substrat auf letzteres abzubilden (Projektionsbelichtung). Bei den früher üblichen Kontaktverfahren wurde bereits vorgeschlagen, den Fotolack mit Überzugsschichten zu versehen, deren Ausbildung auch Gegenstand der vorliegenden Erfindung bildet. Dort (vgl. US-A-3 895 949) hatten die Überzugsschichten jedoch den Zwecks, die Beschädigung des Werkstückes durch die Maske zu vermeiden. Allenfalls sollte durch diese Schichten der Zutritt von Feuchtigkeit und Sauerstoff zum Lack verhindert werden, da dieser bei den damals verwendeten Negativlacken sich im unbelichteten Bereich nicht gänzlich auflöste, wenn Feuchtigkeit oder Sauerstoff in seine Oberflächenschicht eingedrungen waren.

Die Erfindung bezieht sich demgegenüber auf ein Verfahren zur Übertragung eines Musters auf eine mit Fotolack beschichtete Halbleiterscheibe, bei dem Licht über eine das Muster aufweisende Maske durch ein Projektionsobjektiv auf den Fotolack gelangt und dessen belichtete Bereiche nach der Belichtung entfernt werden, und bei dem vor der Belichtung unmittelbar auf den Fotolack ein fester lichtdurchlässiger Überzug aufgebracht wird.

Der verwendete Fotolack ist also ein Positivlack, bei welchem der Zutritt von Feuchtigkeit keineswegs nachteilig ist, sondern die Entwicklung des belichteten Lackes sogar fördert. Dennoch ist auch bei einem Projektionsbelichtungsverfahren, das mit Positivlack arbeitet, bereits einmal die Verwendung eines festen lichtdurchlässigen Überzuges für den Fotolack vorgesehen worden (vgl. DE-A-1 622 302). Es handelte sich dabei jedoch um eine Schicht aus Fotolack, die gegenüber der darunterliegenden Schicht geringere Lichtabsorption aufweisen sollte. Dadurch soll eine wirksame Belichtung des Fotolacks durch vom Körper reflektiertes Licht verhindert werden. Die Dicke der erwähnten Schicht liegt unter 0,3 μm, sodass sie für den anschliessend diskutierten erfindungsgemässen Zweck völlig unwirksam wäre.

Da Alternativen zur optischen Lithographie bei der Herstellung integrierter Schaltungen für die praktische Anwendung noch nicht zur Verfügung stehen bzw. noch nicht hinreichend ausgereift sind, sind weitere Fortschritte vor allem durch die Beseitigung von Nachteilen zu erwarten, die derzeit bei der Anwendung des Projektionsbelichtungsverfahrens auftreten. Die gegenständliche Erfindung zielt dabei vor allem auf eine Verminderung des Kontaminationsproblems ab. Die gefundene Lösung bringt jedoch, wie später ausgeführt werden soll, die Möglichkeit zur Beseitigung einer Reihe von weiteren heute gegebenen Schwierigkeiten.

Verunreinigungen an einer Halbleiterscheibe können sich sowohl zwischen Halbleiter und Fotolack als auch auf der Oberfläche des Fotolackes befinden. Verunreinigende Partikel an der Grenzschicht zwischen Halbleiter und Lack sind dabei weniger kritisch. Falls sie ganz in einem hellen oder dunklen Feld liegen, haben sie überhaupt keine nachteilige Wirkung, da sie dann gewissermassen Füllmaterial für den Lack bilden. Sie bleiben während des Entwicklungsvorganges im Lack und werden entweder mit diesem abgelöst oder weggespült. Kritisch hingegen sind Staubpartikel an der Oberseite des Fotolackes, da sie hier wie Maskenfehler wirken und die gesamte darunter liegende Lackschicht abdecken.

Die Ansammlung von Staubpartikeln an der Oberseite der bereits für die Belichtung vorbereiteten Halbleiterscheibe lässt sich auch bei grösster Vorsicht deshalb so schwer vermeiden, da die Zeit zwischen Fertigstellung und Belichtung nicht in der vom Standpunkt der Reinhaltung der Oberfläche her wünschenswerten Weise abgekürzt werden kann. Zwischen den einzelnen Verfahrensschritten liegen vielmehr oft erhebliche Zeiten, die sich daraus erklären, dass die Herstellung der Halbleiterscheiben in Losen von typischerweise 50 bis 100 Stück erfolgt. Es handelt sich also nicht um Fliessverfahren, bei denen Verweilzeiten minimiert werden können. Bei der Verfahrensführung steht vielmehr die möglichst gleichmässige Auslastung des Maschinenparks im Vordergrund.

Die Erfindung berücksichtigt, dass Verunreinigungen weitgehend unvermeidbar sind und setzt sich zur Aufgabe, deren schädliche Wirkung herabzusetzen. Dies wird dadurch erreicht, dass die Dicke des ebenen Überzuges einen Wert von zumindest einigen μm aufweist, bei dem die durch die Formel

$$A = d \left( \frac{1}{n} - \frac{\cos \delta \max}{n^2 - \sin^2 \delta \max} \right.$$

(d = Dicke des Überzuges, n = Brechungsindex des Überzuges, $\delta$ max = maximaler Öffnungswinkel des auf den Überzug einfallenden Lichtes) definierte sphärische Aberration weniger als die Rayleigh-Tiefe beträgt, und dass der Überzug nach der Belichtung in an sich bekannter Weise gänzlich entfernt wird.

Die sich zwischen der Vorbereitung der Halbleiterscheibe für den Belichtungsvorgang und den Belichtungsvorgang selbst auf der Scheibe ansammelnden Verunreinigungen liegen nun nicht mehr direkt auf dem Fotolack, sondern weisen von diesem einen Abstand auf, sodass Licht den unterhalb der Verunreinigung liegenden Bereich des Fotolackes erreichen kann. Die Wirksamkeit des Überzuges nimmt mit seiner Dicke zu, doch können schon Schichtdicken in der Grössenordnung von einigen μm eine wesentliche Verbesserung bewirken, soferne die verunreinigenden Partikel hinreichend klein sind. Eine obere Grenze für die Dicke des Überzuges ergibt sich dabei dadurch, dass dieser eine planparallele Schicht darstellt, die zu einem Öffnungsfehler führt. Dieser Öffnungsfehler entspricht der sphärischen Aberration, wenn man den planparallelen Überzug als Linse mit unendlichem Krümmungsradius betrachtet. Der Fehler hat zur Folge, dass die unter einem Winkel auftretenden bilderzeugenden Strahlen sich in einer anderen Ebene vereinigen als die senkrecht einfallenden Strahlen, ein Punkt also in eine achsparallele Strecke abgebildet wird. Dies ist so lange zulässig, als die Länge dieser Strecke A in einem vernünftigen Verhältnis zur Schärfentiefe (Rayleigh-Tiefe) steht, welche durch die Formel $t_R = \lambda/NA^2$ definiert ist (NA = numerische Apertur). Hier liegt der Grund dafür, warum erfindungsgemäss nicht beliebig dicke Überzuge zugelassen werden können.

Die Tragweite der Erfindung im Rahmen der Herstellung von integrierten Schaltungen geht dadurch wesentlich über das bisher Angeführte hinaus, als ohne weiteres die Möglichkeit besteht, bei der Wahl des erfindungsgemäss vorgesehenen Überzuges auf die Eigenschaften, insbesondere den Brechungsindex, des verwendeten Fotolackes Rücksicht zu nehmen.

Eines der ganz grossen Probleme bei der Belichtung von Fotolackschichten auf Halbleiterscheiben, insbesondere bei der Erzeugung feiner Strukturen, ist die homogene Belichtung des gesamten Bildfeldes. Eine Ungleichmässigkeit von ca. 1% gilt dabei als guter Richtwert. Die gleichmässige Ausleuchtung des Bildfeldes ist zwar eine notwendige, aber längst noch keine ausreichende Bedingung für das erstrebte Ziel. Dieses wäre nur dann der Fall, wenn die Halbleiterscheibenoberfläche mit der auf ihr befindlichen Lackschicht selbst homogen wäre. Dies ist aber spätestens nach dem ersten Lithographie-Schritt nicht mehr der Fall, da ja nun die ersten gewünschten Strukturen erzeugt worden sind.

Im allgemeinen befinden sich während der verschiedenen Herstellungsschritte einer integrierten Schaltung auf der Halbleiteroberfläche zahlreiche Stufen, Gräben, Erhöhungen, Böschungen etc. Wird nun auf eine solche Oberfläche eine Fotolackschicht aufgebracht, so ergeben sich unweigerlich Schwankungen der Lackdicke. Nach dem Trocknungsprozess folgt das Profil der Lackoberfläche nur bedingt dem Profil der Grenzfläche Lack – Substrat.

Fällt Licht auf eine solche Lackschicht, so treten nacheinander folgende physikalische Erscheinungen auf:

Das auftreffende Licht wird an der Grenzfläche Luft – Lack zum Teil reflektiert, zum Teil gebrochen. Der gebrochene Anteil dringt in die Lackschicht ein und trägt zur Belichtung bei (sofern es sich im Licht der Belichtungswellenlänge handelt). Bei streifender Inzidenz, z.B. an steilen Böschungen der Lackoberfläche, steigt der reflektierte Anteil stark an.

Das eindringende Licht klingt entsprechend dem Schwächungskoeffizienten des Lacks ab, trifft mehr oder weniger geschwächt auf die Grenzfläche Lack – Substrat und wird von dieser teils absorbiert, teils reflektiert.

Dieser reflektierte Anteil bewegt sich seinerseits unter Schwächung wieder auf die Grenzfläche Lack – Luft zu, wird an dieser wiederum teils reflektiert, teils gebrochen transmittiert. An einzelnen Stellen kommt es sogar zur Totalreflexion.

Die innerhalb der Lackschicht hin und her laufenden Lichtwellen interferieren und bilden stehende Wellen aus. Diese stehenden Wellen tragen wesentlich zur Belichtung des Lacks bei. Die Intensität der stehenden Wellen ist in hohem Masse abhängig von der lokalen Lackdicke. Die Ausbildung stehender Wellen wird abgeschwächt, wenn innerhalb des Lacks bzw. an der Grenzfläche Lack – Substrat eine nennenswerte Absorption auftritt. Diese Situation ist aber im allgemeinen nicht gegeben.

Die hohe Reflexion bei streifender Inzidenz an Böschungen und die unterschiedliche Intensität stehender Wellen durch schwankende Lackdicke sind hauptsächlich dafür verantwortlich, dass trotz gleichmässiger Beleuchtung eine inhomogene Belichtung von Lackschichten auf strukturierten Halbleiterscheiben stattfindet. Diese unhomogene Belichtung ist die Ursache für eine Variation der Linienbreiten von aus der Lackschicht zu erzeugenden linienhaften Strukturen. Je stärker die oben genannten Effekte auftreten, um so grösser sind die Anforderungen an den Bildkontrast, d.h. die sogenannten MTF-Werte (von modulation transfer function) müssen dann für eine scharfe Abbildung gross sein. Umgekehrt können beim Fehlen der Störeffekte auch kleinere MTF-Wert verarbeitet werden, d.h. dass bei einer gegebenen numerischen Apertur feinere Linien abgebildet werden können.

Nach dem Stand der Technik gelingt es nur sehr unvollkommen, die erwähnten Störeffekte auszuschalten, indem man versucht, Lackdickenschwankungen gering zu halten und im übrigen Fotolacke mit hoher Eigenabsorption zu verwenden, die aber wiederum den Nachteil hoher Belichtungszeiten aufweisen.

Wird hingegen nach der bevorzugten Ausführungsform der Erfindung die mit einer Lackschicht überzogene Scheibe mit einem Überzug versehen, dessen Brechungsindex mit dem des Lacks übereinstimmt, so verschwindet die Grenzfläche Lack – Überzug vom Standpunkt der Optik aus vollständig. Dies hat zur Folge, dass schon bei geringer Schichtdicke keine streifende Inzidenz mehr auftritt, da die Oberfläche des Überzuges im wesentlichen eben verläuft und der vertikalen Kontur der Halbleiterscheibe praktisch nicht mehr folgt. Ausserdem vermindert sich mit zunehmender Schichtdicke die Bedeutung der durch die Interferenz stehender Wellen hervorgerufenen Beleuchtungsunterschiede. Auf jeden Fall wird das Phänomen der stehenden Wellen vernachlässigbar, sobald die Dicke des Überzuges die halbe Kohärenzlänge des Belichtungslichtes übersteigt, welche bei herkömmlichen Hg-Hochdrucklampen in der Grössenordnung von 10 bis 100 µm liegt. Die Kohärenzlänge, definiert als $l_K = \lambda 2/\Delta \lambda$, ist jedoch ein statistischer Mittelwert, sodass es dann, wenn die Dicke des Überzuges gleich der halben Kohärenzlänge ist nicht schlagartig zum völligen Verschwinden jeglicher Interferenzeffekte kommt, wogegen diese sich aber bereits vor Erreichen dieser Dicke wesentlich vermindern.

Bei der Herstellung des erfindungsgemässen Überzuges wird man zunächst dafür Sorge tragen, dass mit der Aufbringung des Überzuges sofort nach dem Trocknen des Fotolacks, also bevor eine wesentliche Verunreinigung der Oberfläche des Fotolacks stattfinden konnte, begonnen wird. Vorzugsweise wird das schliesslich den festen Überzug bildende Material in gelöster Form aufgetragen, wobei darauf zu achten ist, dass das Lösungsmittel den Fotolack nicht angreift. Besteht der Fotolack beispielsweise aus einem Phenolharz, darf als Lösungsmittel kein Xylol oder Äthylenglykol verwendet werden, sondern z.B. Methanol, Äthanol, Benzol, Chloroform oder Trichloräthylen. Um auch kleinste Zwischenräume auf der Lackoberfläche ausfüllen zu können, soll das Überzugsmaterial in seiner gelösten Form gegenüber dem Lack benetzend wirken. Trotz guter Benetzung muss das gelöste Überzugsmaterial aber leicht von der Lackschickt entfernbar sein, damit eine problemlose Weiterbearbeitung möglich ist. Eine beschränkte Aufnahmefähigkeit von Wasser ist vorteilhaft, da kleinste Wassertröpfchen auf der Lackoberfläche, die nicht ganz vermeidbar sind, dadurch aufgelöst und optisch unwirksam gemacht werden.

Bevorzugt für die Herstellung der erfindungsgemässen Schicht ist mit einem der genannten Lösungsmittel verdünnter Canadabalsam. Dieser wird, ähnlich wie dies für Fotolack üblich ist, mit einem Spinner aufgetragen. Gleichzeitig oder darnach wird die Halbleiterscheibe auf eine Temperatur erwärmt, welche den Fotolack nicht schädigt, beispielsweise auf 90 °C, um das Lösungsmittel auszutreiben. Wesentlich ist, dass nun die Halbleiterscheibe in genau horizontaler Lage ruht, damit sich in der folgenden Abkühl- und Erstarrungsphase eine planparallele spiegelglatte Oberfläche des aus dem Feststoffanteil des Canadabalsams bestehenden, beispielsweise 10 µm dicken Überzuges bildet.

Nach der Belichtung der in der beschriebenen Weise präparierten Halbleiterscheibe wird der Überzug abgelöst, ohne den belichteten Fotolack anzugreifen, also wieder mit einem der genannten Lösungsmittel, wie Methanol, Äthanol od. dgl. Die freigelegte Fotolackschicht wird in bekannter Weise entwickelt, beispielsweise indem die belichteten Stellen des aus Phenolharz bestehenden Positivlacks mit Natronlauge herausgelöst werden. Daran schliessen sich die weiteren in der Halbleitertechnik üblichen Schritte.

Weitere Einzelheiten der Erfindung werden anschliessend anhand der Zeichnung näher erläutert.

Dabei zeigt:
Fig. 1 schematisch eine Einrichtung zur Projektionsbelichtung auf Halbleiterscheiben,
Fig. 2 den Strahlengang durch eine mit dem erfindungsgemässen Überzug versehene Halbleiterscheibe im Bereich eines Staubteilchens,
Fig. 3 einen mikroskopischen Querschnitt durch die Oberfläche der noch nicht mit dem erfindungsgemässen Überzug versehenen Halbleiterscheibe,
Fig. 4 die schematische Darstellung einer unebenen Oberfläche zur Erläuterung des Phänomens der streifenden Inzidenz, und
Fig. 5 eine Hilfszeichnung zum Verständnis des Auftretens stehender Wellen.

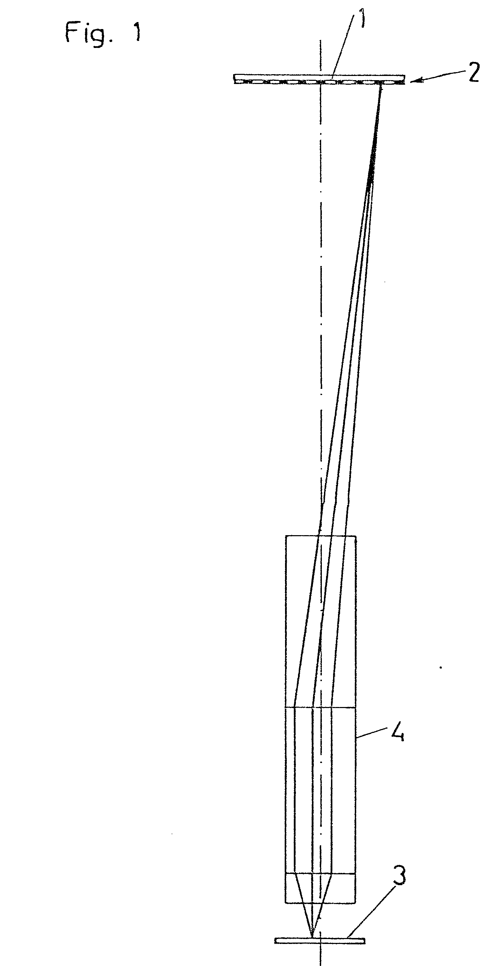

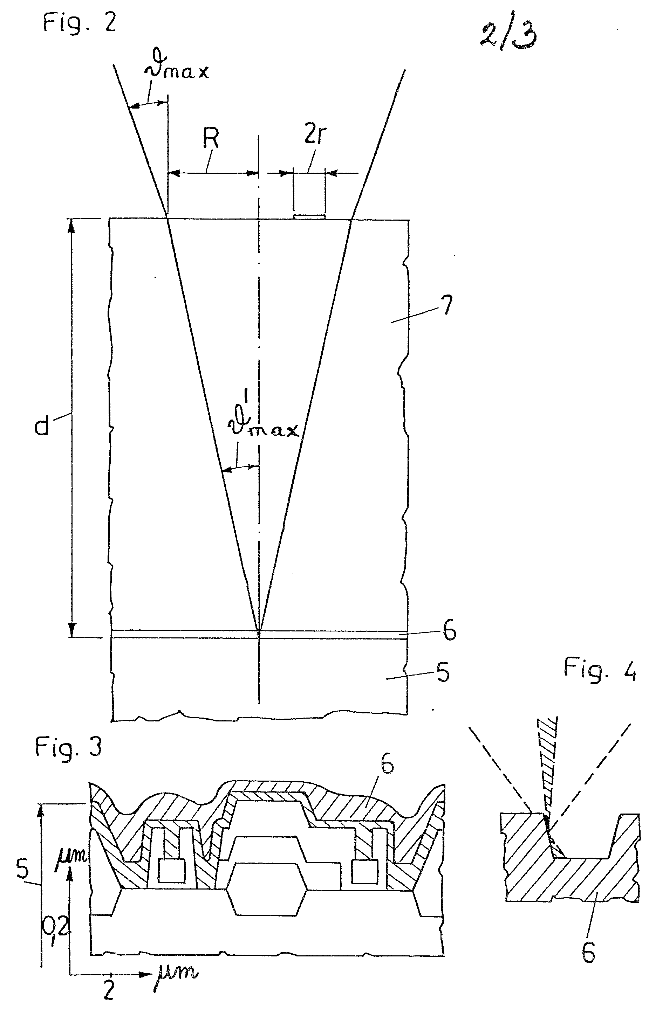

Das Verfahren zur Übertragung eines Musters auf eine mit Fotolack beschichtete Halbleiterscheibe ist in Fig. 1 ganz schematisch dargestellt, da es ja als solches zum Stand der Technik gehört. Licht einer zur chemischen oder physikalischen Veränderung von Fotolack geeigneten Wellenlänge gelangt über eine nicht dargestellte Lichtquelle auf eine mit einer Maske 2 versehene Trägerscheibe 1. Die hellen und dunklen Stellen der Maske 2 werden durch ein Projektionsobjektiv 4 auf eine üblicherweise als Wafer bezeichnete Halbleiterscheibe 3 scharf abgebildet. Die Halbleiterscheibe 3 weist während ihrer Belichtung nicht nur eine lichtempfindliche Lackschicht 6 auf der eigentlichen Halbleiterschicht 5 auf, sondern letztere ist zusätzlich mit einem Überzug 7 versehen. Die Wirkung dieses Überzuges im Sinne einer Herabsetzung der Bedeutung unvermeidlicher Verunreinigungen ist anhand von Fig. 2 leicht verständlich. Licht, das mit einem maximalen Öffnungswinkel $\delta_{max}$ entsprechend einer numerischen Apertur (NA) sin $\delta_{max}$ auf den Überzug 7 der Dicke d auffällt, wird mit zunehmender Dicke d durch eine auf dem Überzug abgelagerte Scheibe mit dem Radius r, welche ein Staubpartikel verkörpern soll, immer weniger stark abgeblendet. Soll beispielsweise durch Partikel mit einem Durchmesser von 2 µm, welche bei unmittelbarem Aufliegen auf dem Fotolack 6 ein Halbleiterelement unbrauchbar machen könnten, lediglich eine lokale Beleuchtungsinhomogenität p zulässigen Ausmasses bewirkt werden, lässt sich die Dicke d des Überzuges wie folgt berechnen:

$$\sin \delta_{max} = NA = n \cdot \sin \delta' = n\, tg\, \delta'$$

$$tg\, \delta'_{max} = \frac{R}{d} \quad \frac{r^2\pi}{R^2\pi} = \frac{p}{100}$$

$$d = \frac{R}{tg\, \delta'_{max}} = \frac{r \cdot 10 \cdot n}{\sqrt{p}\; NA}$$

Unter Annahme eines Brechungsindex von 1,6 sowohl für den Überzug 7 wie für den Fotolack 6 und einer numerischen Apertur von 0,35 ergibt sich, dass die ohne weiteres zulässige lokale Beleuchtungsinhomogenität von 9% bereits mit einem Überzug von der Dicke d = 16 μm erzielt werden kann.

Wie aus Fig. 3 hervorgeht, weist die fotoempfindliche Lackschicht 6 auf dem Halbleiter 5 erhebliche Dickenunterschiede auf. Diese rühren daher, dass nach dem Auftragen der flüssige Lack zunächst ungeachtet der darunterliegenden Struktur eine ebene Lackoberfläche bildet, die nach dem Trocknen infolge des Entweichens des Lösungsmittels zwar in etwa, jedoch nicht genau, dem Profil der Substratoberfläche folgt. Vertiefungen der Oberfläche sind mit einer wesentlich höheren Lackschicht bedeckt als Vorsprünge der Oberfläche.

Die dargestellten Schwankungen in der Lackdicke führen dadurch zu erheblichen Konsequenzen, als es von der Lackdicke abhängt, ob sich die in der Lackschicht entstehenden stehenden Wellen durch Interferenz verstärken oder schwächen. Betreffend die dieser Erscheinung zugrunde liegende Theorie wird beispielsweise auf die Arbeiten

J.D. Cuthbert, Solid State Technology, August 1977, Seite 59

Dietrich W. Widmann, Applied Optics, April 1975, Vol 14, No. 4, Seite 932

Dietrich W. Widmann and Hans Binder, IEEE Transactions on Electron Devices, Vol. ED-22, No. 7, July 1975, Seite 467–469

verwiesen. Im ungünstigsten Fall kann durch Unterschiede in der Lackdicke trotz homogener Belichtung ein örtlicher Unterschied in der Belichtungsintensität entstehen, welcher für die wenig belichteten Bereiche eine Verlängerung der Belichtungszeit um den Faktor 2,5 bedingt. Gravierender als die dadurch generell notwendig werdende Verlängerung der Belichtungszeit ist die Tatsache, dass die durch die Dickenunterschiede der Lackschicht bedingte verschiedene Lichtempfindlichkeit der einzelnen Oberflächenbereiche höhere Anforderungen an den Bildkontrast bedingt, d.h. die Möglichkeit der Abbildung feinerer Linien herabsetzt.

Der Versuch, die Lackdicke möglichst konstant zu machen, um den erwähnten Nachteil zu verringern, ist einerseits nur wenig aussichtsreich, andererseits würden bei genauer Nachbildung der Vertikalstruktur des Halbleiters 5 durch den Fotolack 6 an der Oberseite der Lackschicht 6 Unebenheiten entstehen, die ihrerseits den aus Fig. 4 ersichtlichen Nachteil haben.

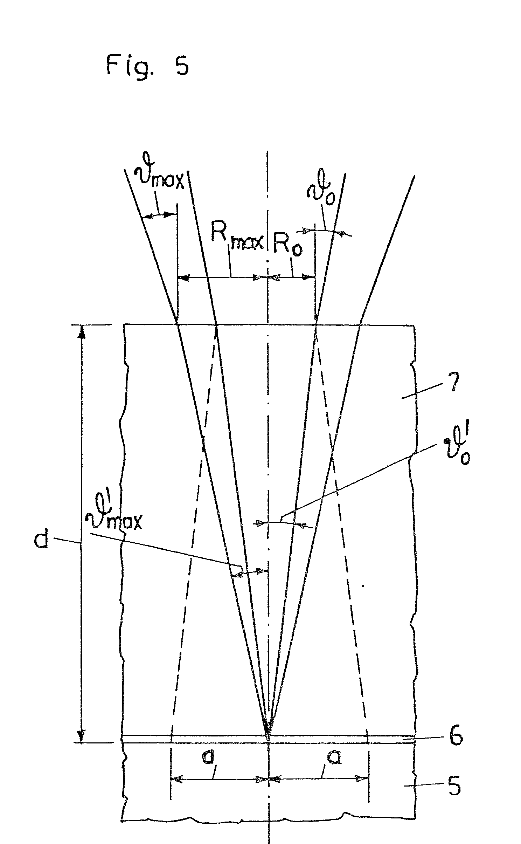

Wie man aus Fig. 4 sieht, bedingt streifende Inzidenz des Lichtes an den zu einer Vertiefung führenden Böschungen eine Überbelichtung des Grundes der Vertiefung durch reflektierte Strahlen. Dieser Effekt könnte nur dadurch zum Verschwinden gebracht werden, dass dem Fotolack eine ebene Oberfläche erteilt wird, was wiederum mit der Forderung nach konstanter Dicke nicht vereinbar ist. Die Erfindung führt aus dem aufgezeigten Dilemma, indem sie in ihrer bevorzugten Ausführung auf die Lackschicht 6 einen Überzug 7 aufbringt, dessen Brechungsindex dem des Fotolackes weitgehend angeglichen ist. Optisch bilden damit Fotolack und Überzug eine einzige Schicht. Die Oberseite dieser Schicht kann ohne weiteres praktisch eben gestaltet werden, sodass zunächst das Problem der streifenden Inzidenz gegenstandslos wird. Gleichzeitig – und dies ist praktisch von grösserer Bedeutung – treten in einer solchen Schicht, deren Dicke ein Mehrfaches der Belichtungswellenlänge beträgt, die erwähnten Interferenzerscheinungen nur mehr in unschädlichem Ausmass auf. Eine gewisse Schichtdicke ist für das Unschädlichwerden der Interferenzerscheinungen Voraussetzung. In diesem Sinne wäre es möglich, die Schichtdicke grösser als die halbe Kohärenzlänge zu machen, doch wird anschliessend anhand von Fig. 5 gezeigt, dass Schichten solcher Dicken, obwohl sie vom Öffnungsfehler her zulässig wären, im allgemeinen nicht erforderlich sind, um den Einfluss stehender Wellen in der Praxis vernachlässigen zu können.

Bezeichnet a das Auflösungsvermögen des Projektionsobjektivs, also den geringsten Abstand, in dem zwei Striche getrennt voneinander auf der Halbleiterschicht 5 aufgebracht werden können, so ist davon auszugehen, dass einfallende Strahlen, die zunächst an der Grenzschicht Fotolack 6 – Halbleiter 5 und dann an der Grenzschicht Überzug 7 – Luft wieder zurück in den Fotolack reflektiert werden, nur dann in beachtenswertem Ausmass zu Interferenzerscheinungen beitragen, als sie innerhalb eines Kreises mit dem Radius a um den Bildpunkt auftreffen. Diese Strahlen stellen innerhalb des Gesamtbündels mit dem Öffnungswinkel $\delta_{max}$ ein Bündel mit dem kleineren Öffnungswinkel $\delta_0$ dar, das mit der Oberseite des Überzuges 7 einen Kreis vom Radius $R_0 = \dfrac{a}{2}$

bildet. Es ist unmittelbar einzusehen, dass ganz analog zu den Überlegungen, die im Zusammenhang mit Fig. 2 angestellt worden sind, mit zunehmender Dicke d des Überzuges 7 der Einfluss dieses durch den Kreis mit dem Radius $R_0$ gehenden Bündels abnimmt. Der Anteil des unter dem maximalen Öffnungswinkel $\delta_{max}$ einfallenden Lichtes, der innerhalb des Winkels $\delta_0$ liegt und damit überhaupt durch das Auftreten stehender Wellen wesentlich beeinflusst wird, ergibt sich nach einfacher Rechnung

etwa als $\dfrac{a^2 n^2}{4\, d^2\, NA^2}$

und kann somit offensichtlich durch Wahl eines Überzuges 7 von entsprechender Dicke d relativ bedeutungslos gemacht werden. Ein Überzug von der Dicke d = 5 μm kann in diesem Sinne bereits durchaus hinreichend sein. Damit steht für die Wahl der gewünschten Dicke des Überzuges sowohl vom Standpunkt des Kontaminationsproblems als auch vom Standpunkt des Problems stehender Wellen ein relativ weiter Bereich von wenigen μm bis zu etwa 50 μm zur Verfügung, in welchem die Dicke des Überzuges nach den Herstellungserfordernissen gewählt werden kann. Eine relativ dünne Schicht ist dabei im allgemeinen leichter herzustellen und insbesondere auch mit geringerem Aufwand wieder abzulösen.

Es wird nicht verkannt, dass mit Verringerung von $\delta_0$ bei zunehmender Dicke d des Überzuges nur mehr ein bescheidener Teil des zweimal reflektierten Lichtes zur scharfen Abbildung der Maske beiträgt. Dies ist jedoch unbedenklich, da der Anteil des zweimal reflektierten Lichtes an der Gesamtintensität sogar bei senkrechtem Einfall nicht grösser ist als $\left[\dfrac{n-1}{n+1}\right]^2$, was bei n =

1,6 einem Wert von etwa 5% entspricht.

**Patentansprüche:**

1. Verfahren zur Übertragung eines Musters auf eine mit Fotolack beschichtete Halbleiterscheibe, bei dem Licht über eine das Muster aufweisende Maske durch ein Projektionsobjektiv auf den Fotolack gelangt und dessen belichtete Bereiche nach der Belichtung entfernt werden, und bei dem vor der Belichtung unmittelbar auf den Fotolack ein fester, lichtdurchlässiger Überzug aufgebracht wird, dadurch gekennzeichnet, dass die Dicke des ebenen Überzuges einen Wert von zumindest einigen μm aufweist, bei dem die durch die Formel

$$A = d\left(\frac{1}{n} - \frac{\cos \delta max}{\sqrt{n^2 - \sin^2 \delta max}}\right)$$

(d = Dicke des Überzuges, n = Brechungsindex des Überzuges, δmax = maximaler Öffnungswinkel des auf den Überzug einfallenden Lichtes) definierte sphärische Aberration weniger als die Rayleigh-Tiefe beträgt, und dass der Überzug nach der Belichtung in an sich bekannter Weise gänzlich entfernt wird.

2. Verfahren nach Anspruch 1, dadurch gekennzeichnet, dass die Dicke des Überzuges weniger als ein Drittel der Rayleigh-Tiefe beträgt.

3. Verfahren nach Anspruch 1 oder 2, dadurch gekennzeichnet, dass der Überzug sofort nach dem Trocknen des Fotolackes, bevor eine wesentliche Verunreinigung der Oberfläche des Fotolackes stattfinden kann, aufgebracht wird.

4. Verfahren nach einem der Ansprüche 1 bis 3, dadurch gekennzeichnet, dass der Überzug in einer Dicke aufgebracht wird, die wenigstens dem durch die Formel

$$d = \frac{10.r.n}{Na.\sqrt{p}}$$

gegebenen Wert entspricht, wobei d = Dicke des Überzuges, r = mittlerer Radius der Staubpartikel, n = Brechungsindex des Überzuges, NA = numerische Apertur, p = zulässiger Prozentsatz der Beleuchtungsinhomogenität gilt.

5. Verfahren nach einem der Ansprüche 1 bis 4, dadurch gekennzeichnet, dass der Überzug mit einem Brechungsindex hergestellt wird, der weitgehend dem Brechungsindex des Fotolackes entspricht und vorzugsweise nicht mehr als 10% von diesem abweicht.

6. Verfahren nach einem der Ansprüche 1 bis 5, dadurch gekennzeichnet, dass der Überzug aufgebracht wird, indem mit einem den Fotolack nicht angreifenden Lösungsmittel versehener Kanadabalsam aufgetragen, verteilt und zur Vertreibung des Lösungsmittels auf eine den Fotolack nicht schädigende Temperatur, vorzugsweise eine Temperatur unterhalb 363,15 K (90 °C), erwärmt wird, während die Halbleiterscheibe in genau horizontaler Lage angeordnet ist.

**Revendications**

1. Procédé pour le transfert d'un modèle sur une tranche semiconductrice enduite de laque photosensible, dans lequel au-delà d'un masque portant le modèle, la lumière tombe sur la laque photosensible à travers l'objectif de projection et les régions exposées de cette laque sont éliminées après l'exposition et dans lequel un revêtement translucide solide est déposé directement sur la laque photosensible avant l'exposition, caractérisé en ce que l'épaisseur du revêtement plan possède une valeur d'au moins quelques μm, dans lequel l'aberration sphérique définie par la formule

$$A = d\left(\frac{1}{n} - \frac{\cos \delta_{max}}{\sqrt{n^2 - \sin^2 \delta_{max}}}\right)$$

(d = épaisseur du revêtement, n = indice de réfraction du revêtement, $\delta_{max}$ = angle d'ouverture maximum de la lumière tombant sur le revêtement) est plus petite que la profondeur de Rayleigh et en ce que, après l'exposition, on élimine totalement le revêtement d'une façon connue en soi.

2. Procédé suivant la revendication 1, caractérisé en ce que l'épaisseur du revêtement est inférieure à un tiers de la profondeur de Rayleigh.

3. Procédé suivant la revendication 1 ou 2, caractérisé en ce que le revêtement est déposé aussitôt après le séchage de la laque photosensible, avant qu'il ne puisse se produire une contamination notable de la surface de la laque photosensible.

4. Procédé suivant l'une des revendications 1 à 3, caractérisé en ce que le revêtement est déposé en une épaisseur qui correspond au moins à la valeur donnée par la formule

$$d = \frac{10.r.n}{NA.\sqrt{p}}$$

où d = épaisseur de revêtement, r = rayon moyen des particules de poussière, n = indice de réfraction du revêtement, NA = ouverture numérique, p = pourcentage admissible du défaut d'homogénéité de l'éclairement.

5. Procédé suivant l'une des revendications 1 à 3, caractérisé en ce que le revêtement est réalisé avec un indice de réfraction qui correspond dans une large mesure à l'indice de réfraction de la laque photosensible et qui, de préférence, ne s'écarte pas de ce dernier de plus de 10%.

6. Procédé suivant l'une des revendications 1 à 4, caractérisé en ce que le revêtement est formé par le fait qu'on dépose du baume du Canada muni d'un solvant qui n'attaque pas la laque photosensible, qu'on le répartit et qu'on le chauffe à une température ne détériorant pas la laque photosensible, de préférence une température inférieure à 363,15 K (90 °C), pour chasser le solvant, alors que la tranche semiconductrice est disposée dans une position exactement horizontale.

**Claims**

1. Method for transferring a pattern to a semiconductor disk covered with a photosensitive resist, where light passes via a mask provided with a pattern through a projection objective onto the photosensitive resist and the exposed areas thereof are removed after the exposure, and where before the exposure a solid, light-transparent coating is applied directly to the photosensitive resist, characterized in that the thickness of the planar coating has a value of at least some μm, where the spherical aberration defined by the formula

$$A = d \left( \frac{1}{n} - \frac{\cos \delta max}{n^2 - \sin^2 \delta max} \right)$$

(d = thickness of the coating, n = index of refraction of the coating, δmax = maximum aperture angle of the light impinging onto the coating) amounts to less than the Raleigh depth, and that the coating is completely removed after exposure in a manner known per se.

2. Method according to claim 1, characterized in that the thickness of the coating is less than a third of the Raleigh depth.

3. Method according to claim 1 or 2, characterized in that the coating is applied immediately after the drying of the photosensitive resist before a substantial contamination of the surface of the photosensitive resist can take place.

4. Method according to claims 1 to 3, characterized in that the coating is applied in a thickness which corresponds at least to the value provided by the formula

$$d = \frac{10.r.n}{NA.\sqrt{p}}$$

where d = thickness of the coating, r = average radius of the dust particles, n = index of refraction of the coating, NA = numerical aperture, p = allowed percentage of the exposure inhomogeneity.

5. Method according to one of claims 1 to 4, characterized in that the coating is provided with an index of refraction which corresponds substantially to the index of refraction of the photosensitive resist and which preferably does not deviate from the same by more than 10%.

6. Method according to one of claims 1 to 5, characterized in that the coating is applied by employing canada balsam provided with a solvent not attacking the photosensitive resist, is distributed and, for removal of the solvent, warmed to a temperature not causing damage to the photosensitive resist, preferably a temperature below 363,15 K (90 °C), while the semiconductor disk is arranged in an exactly horizontal position.

Fig. 1

Fig. 2

Fig. 3

Fig. 4

3/3

Fig. 5